# EUROPÄISCHE PATENTSCHRIFT

(11) **EP 1 178 322 B1**
(45) Veröffentlichungstag und Bekanntmachung des Hinweises auf die Patenterteilung: **02.11.2005**
(21) Anmeldenummer: 01000340.8
(22) Anmeldetag: 02.08.2001
(51) Int. Cl.: G01R 31/3187, G01R 31/3185

(54) **Integrierter Schaltkreis mit Selbsttest-Schaltung**
Integrated circuit with self-test portion
Circuit intégré muni d'un circuit d'auto-test

(30) Priorität: 05.08.2000 DE 10038327
(43) Veröffentlichungstag der Anmeldung: 06.02.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Hapke, Friedrich c/o Philips Corp. Int. Property, 52064, Aachen (DE)
(74) Vertreter: Volmer, Georg

(56) Entgegenhaltungen:
- EP-A- 0 780 767
- US-A- 5 784 383
- KIEFER G ET AL: "USING BIST CONTROL FOR PATTERN GENERATION" PROCEEDINGS OF THE INTERNATIONAL TEST CONFERENCE. ITC '97. WASHINGTON, DC, NOV. 1 - 6, 1997, INTERNATIONAL TEST CONFERENCE, NEW YORK, NY: IEEE, US, Bd. CONF. 28, 1. November 1997 (1997-11-01), Seiten 347-355, XP000800332 ISBN: 0-7803-4210-0

## Beschreibung

Die Erfindung betrifft einen integrierten Schaltkreis mit einer zu testenden Applikationsschaltung und einer Selbsttest-Schaltung, welche zum Testen der Applikationsschaltung vorgesehen ist, und welche einer Anordnung zur Erzeugung deterministischer Testmuster aufweist, die der Applikationsschaltung für Testzwecke zugeführt werden, wobei die durch die Applikationsschaltung in Abhängigkeit der Testmuster auftretenden Ausgangssignale mittels eines Signaturregisters ausgewertet werden.

Beim Herstellen von integrierten Schaltungen besteht ganz allgemein der Wunsch, diese auf ihre Funktion hin zu überprüfen. Derartige Tests können durch externe Testanordnungen vorgenommen werden. Bedingt durch die sehr hohe Integrationsdichte derartiger Schaltungen, die sehr hohen Taktraten, mit denen diese Schaltungen arbeiten, und der sehr großen erforderlichen Anzahl von Testvektoren treten bei dem externen Test viele Probleme und Kosten auf. Die hohen internen Taktraten der integrierten Schaltungen stehen in einem ungünstigen Verhältnis zu den vergleichsweise sehr langsamen Input/Output-Bondpadstufen, die nach außen führen. Daher ist es wünschenswert, eine Art Selbsttest des integrierten Schaltkreises durchführen zu können. Dabei ist innerhalb des integrierten Schaltkreises eine Selbsttest-Schaltung vorgesehen, welche dazu dient, die in dem integrierten Schaltkreis ebenfalls vorgesehene Applikationsschaltung zu testen. Die Applikationsechaltung stellt diejenige Schaltung dar, die für den eigentlichen Einsatzzweck des integrierten Schaltkreises vorgesehen ist.

Als weiteres Problem treten beim Testen derartiger Schaltungen Probleme mit solchen Bauteilen innerhalb der Schaltung auf, die beim Testen ein sogenanntes "X" produzieren, d h ein Signal, welches nicht eindeutig auswertbar ist. Solche Signale produzieren insbesondere solche Bauteile, die ein analoges oder ein Speicherverhalten aufweisen. Z. B. RAMs, die innerhalb der Applikationsschaltung vorgesehen sind, können beliebige Ausgangssignale produzieren. Damit sind Signale, die ein derartiges RAM produziert und die durch die Schaltung propagiert werden am Ausgang der Schaltung beim Testen nicht mehr eindeutig auswertbar.

Zur Umgehung dieser Problematik ist es nach dem Stande der Technik bekannt, innerhalb der Schaltung spezielle Bauelemente vorzusehen, die beim Testen ein Umgehen derartiger Bauelemente oder ein Maskieren der Ausgänge dieser Bauelemente gestatten. Hierbei besteht der Nachteil, dass zusätzliche Bauelemente innerhalb der Schaltung vorgesehen werden müssen, was einerseits einen erhöhten Aufwand und andererseits eine spezielle Auslegung der Schaltung mit ggf. auftretenden Nachteilen zur Folge hat.

Aus der Veröffentlichung "Using BIST control for pattern generation" von Gundolf Kiefer und Hans-Joachim Wunderlich (veröffentlicht in Procedings International Testconference 1997) ist ein integrierter Schaltkreis mit einer zu testenden Applikationsschaltung und einer Selbsttest-Schaltung bekannt, welche deterministische Testmuster liefert. Dies wird dadurch erreicht, dass zusätzlich zu einem Testmustergenerator, bei dem es sich um ein rückgekoppeltes Schieberegister handelt und der Pseudo-Zufallsmuster liefert, eine Logik vorgesehen ist, die das Ausgangssignal dieses Testmustergenerators so verändert, dass bestimmte deterministische Testmuster entstehen. Damit kann erreicht werden, dass die Schaltung mit vorgebbaren Testmustern geprüft werden kann und nicht nur mit solchen, die quasi zufällig durch den Testmustergenerator vorgegeben werden.

Aus der EP 0 780 767 A ist eine Anordnung für den Boundary-Scan-Test bekannt, die auf einer Test- Schaltkreisplatine aufgebaut ist, die eine Testlogik enthält, die in der Lage ist, beim Testen diejenigen Bits des Ausgangssignals eines Testmusters zu sperren, die undefinierte Zustände aufweisen.

Es ist Aufgabe der Erfindung, den eingangs genannten integrierten Schaltkreis dahingehend weiterzuentwickeln, dass eine Prüfung der Applikationsschaltung mit deterministischen Testmustern möglich ist, und dass gleichzeitig innerhalb der Schaltung auftretende X-Signale beim Testen das Prüfergebnis nicht stören, wobei innerhalb der Applikationsschaltung keine zusätzlichen Bauelemente vorgesehen sein sollen.

Diese Aufgabe wird erfindungsgemäß dadurch gelöst, dass in der Selbsttest-Schaltung eine Maskierungslogik vorgesehen ist, welche beim Testen diejenigen Bits der Ausgangssignale der Applikationsschaltung sperrt, die aufgrund des Schaltungsaufbaus undefinierte Zustände aufweisen, und welche nur die übrigen Bits dem Signaturregister zuführt, und dass der Maskierungslogik ein Testmuster-Zähler zugeordnet ist, welcher der Maskierungslogik ein Signal liefert, das dieser in einem Test laufend eine Kennummer des aktiven Testmusters übermittelt.

Die von der Selbsttest-Schaltung generierten Testmuster sind deterministisch, d. h. es handelt sich um vorgegebene Testmuster. Diese Testmuster werden der Applikationsschaltung zugeführt, die die Testmuster bedingt durch den Aufbau der Applikationsschaltung verändert. Die dadurch beim Testen entstehenden Ausgangssignale der Applikationsschaltung werden auf das Signaturregister gekoppelt. Das Signaturregister verknüpft diese Ausgangssignale, die aus mehrere Testzyklen kommen zu einem Gesamtendergebnis, welches eine Art Signatur darstellt und welches angibt, ob die Schaltung störungsfrei arbeitet.

Bei dieser Vorgehensweise entstehen jedoch dann Probleme, wenn in der Applikationsschaltung fast immer vorgesehene Bauelemente, die ein analoges oder ein Speicherverhalten aufweisen, die Ausgangssignale der Applikationsschaltung beim Testen beeinflussen. Es entstehen dann sogenannte X-Signale, die ein "Don't care-Ergebnis" liefern. Mit anderen Worten, sind mit einem derartigen X markierte Signale nicht auswertbar. Damit entstehen für derartige Signale in dem Signaturregister ebenfalls nicht auswertbare Werte. Dies ist zu vermeiden.

Erfindungsgemäß wird dies dadurch erreicht, dass eine Maskierungslogik vorgesehen ist. Die Maskierungslogik sperrt beim Testen der Schaltung alle diejenigen Bits in den Ausgangssignalen der Applikationsschaltung, die potentiell derartige X-Signale beinhalten, also alle diejenigen Bits, die durch ein speicherndes bzw. analoges Verhalten von Bauelementen innerhalb der Applikationsschaltung beeinflusst sind. Die Maskierungslogik lässt nur die übrigen von derartigen Bauelementen nicht beeinflussten Bits an das Signaturregister durch.

Damit ist sichergestellt, dass diejenigen Bits, die das Signaturregister beim Testen erreichen, durchweg auswertbar sind. Dies wiederum bedeutet, dass das Signaturergebnis, das in dem Signaturregister nach dem Durchlauf mehrerer Testzyklen steht, vollständig auswertbar ist, und ein sicheres Testergebnis liefert.

Ein wesentlicher Vorteil des erfindungsgemäßen integrierten Schaltkreises mit Selbsttest-Schaltung besteht darin, dass die Applikationsschaltung für die Testvorgänge nicht modifiziert werden muss, d. h. sie kann so aufgebaut werden, wie es für die Anwendung der Applikationsschaltung optimal ist. Die Selbsttest-Schaltung beeinflusst die normale Arbeitsweise der Applikationsschaltung in ihrer Anwendung in keiner Weise.

Weiterhin gestattet es die erfindungsgemäße Selbsttest-Schaltung, einen Test der Applikationsschaltung auf dem Chip vorzunehmen, so dass relativ langsame Bondpadverbindungen das Testen nicht stören und der Betrieb der Applikationsschaltung mit maximalen Taktraten vorgenommen werden kann.

Ferner wird der vorgesehene Testmuster-Zähler vorteilhaft dazu eingesetzt, der Maskierungslogik ein Signal zu liefern, aus welchem dieser bekannt ist, welches Testmuster innerhalb mehrerer Testdurchläufe gerade die Applikationsschaltung passiert, so dass die Maskierungslogik entsprechend die für diesen Durchlauf von speichernden oder analogen Bauelementen beeinflusste Bits in dem Ausgangssignal der Applikationsschaltung beim Testen sperren kann.

Ein gemäß einer weiteren Ausgestaltung der Erfindung nach Anspruch 2 vorgesehener Schiebezyklus-Zähler signalisiert der Maskierungslogik den Stand von in der Applikationsschaltung vorgesehenen Schieberegistern. Damit ist bekannt, welche Bits der Schieberegister durch die Maskierungslogik gesperrt werden sollen, und welche nicht.

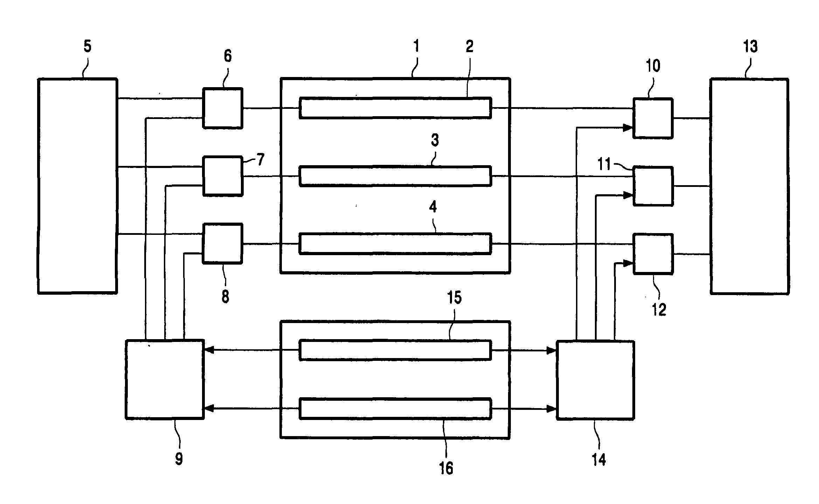

Nachfolgend wird anhand der einzigen Figur der Zeichnung ein Ausführungsbeispiel der Erfindung näher erläutert.

Die Figur zeigt in einem schematischen Blockschaltbild einen integrierten Schaltkreis, welcher eine Applikationsschaltung 1 aufweist. Bei dieser Applikationsschaltung handelt es sich um diejenige Schaltung, welche für den Einsatz des integrierten Schaltkreises konzipiert ist.

Es besteht der Wunsch, die Applikationsschaltung 1 nach der Fertigung des integrierten Schaltkreises auf einwandfreie Funktion hin zu testen. Dazu ist auf dem integrierten Schaltkreis eine Selbsttest-Schaltung vorgesehen, welche aus den Schaltungselementen 5 bis 16 gemäß der Figur besteht.

In dem erfindungsgemäßen integrierten Schaltkreis ist diese Selbsttest-Schaltung so ausgelegt, dass sie vollständig außerhalb der Applikationsschaltung 1 aufgebaut ist, und damit deren Verhalten in dem normalen Betrieb nicht beeinflusst.

In dem Ausführungsbeispiel gemäß der Figur wird davon ausgegangen, dass die Applikationsschaltung 1 drei Schaltungsketten 2, 3 und 4 aufweist, bei denen es sich um Schieberegister handelt. Es können auch mehr Schieberegister vorgesehen sein.

Innerhalb der Selbsttest-Schaltung ist eine lineares rückgekoppeltes Schieberegister 5 vorgesehen, welches eine Pseudo-Zufallsfolge von Testmustern liefert. Da das Schieberegister 5 rückgekoppelt ist und nur endliche Länge hat, ist diese Testmusterfolge nicht wirklich zufällig, sie weist ein nach bestimmten Abständen sich wiederholendes Muster auf. Jedoch hat diese Testmusterfolge den Nachteil, dass sie nicht wirklich solche Testmuster gezielt enthält, die für das Testen der Applikationsschaltung 1 optimal sind.

Daher ist eine Bitmodifikationsschaltung 9 vorgesehen, welche über Verknüpfungslogiken 6, 7 und 8 die Ausgangssignale des linearen rückgekoppelten Schieberegisters 5 so verändert, dass an den Ausgängen der Verknüpfungslogiken 6, 7 und 8 und damit an den Eingängen der Applikationsschaltung 1 bzw. deren Schaltungsketten 2, 3 bzw. 4 Testmuster entstehen, die eine vorgebbare und deterministische Struktur haben. Dies wird dadurch erreicht, dass die Bitmodifikationsschaltung 9 mittels der Verknüpfungslogiken 6, 7 und 8 einzelne Bits der von dem linearen rückgekoppelten Schieberegister 5 gelieferten Testmuster so modifiziert, dass gewünschte, deterministische Testmuster entstehen.

Diese werden in dem Ausführungsbeispiel gemäß der Figur die in Schaltungsketten 2, 3 und 4 innerhalb der Applikationsschaltung 1 zugeführt.

Aufgrund dieser Testmuster liefern die Schaltungsketten 2, 3 und 4 innerhalb der Applikationsschaltung 1 Ausgangssignale, welche über Oder-Gatter 10, 11 und 12 auf ein Signaturregister 13 gelangen.

Das Signaturregister (13 ist so ausgelegt, dass es über mehrere Testzyklen, die jeweils ein Testmuster enthalten, hinweg eine Verknüpfung der Testergebnisse vornimmt und nach dem Testdurchlauf eine sogenannte Signatur liefert, welche bei störungsfreier Arbeitsweise der Applikationsschaltung 1 einen bestimmten vorgegebenen Wert aufweisen muss.

Hierbei besteht jedoch das Problem, dass in der Applikationsschaltung 1 bzw. innerhalb deren Schaltungsketten 2, 3 und/oder 4 Schaltungselemente vorgesehen sein können (und meist auch tatsächlich sind), welche ein analoges oder ein Speicherverhalten aufweisen. Derartige Schaltungselemente liefern kein eindeutiges Ausgangssignal, d. h sie liefern in Abhängigkeit des ihnen zugeführten Eingangssignals kein deterministisches Ausgangssignal. Vielmehr ist ihr Ausgangssignal zufällig. Es ist klar, dass derartige Signale das Testergebnis nicht nur stören, sondern bestimmte Bits innerhalb des Testergebnisses unbrauchbar machen.

Um dennoch mittels eines möglichst einfachen Aufbaus einen Test der Applikationsechaltung 1 auch mit derartigen Bauelementen vornehmen zu können, ist in der erfindungsgemäßen Schaltung eine Maskierungslogik 14 vorgesehen, welche Steuersignale an die Oder-Gatter 10, 11 und 12 liefert. Mittels dieser Signale steuert die Maskierungslogik 14 die Oder-Gatter 10, 11 und 12 so, dass nur diejenigen Bits beim Testen an das Signaturregister 13 gelangen, die nicht von Bauelementen mit speicherndem oder analogem Verhalten beeinflusst sind.

Im Ergebnis gelangen damit nur solche Bits an das Signaturregister (13), die eindeutig auswertbar sind und ein eindeutiges Ergebnis liefern. Somit kann auch dann, wenn die Applikationsschaltung (1) Bauelemente mit speicherndem oder analogem Verhalten aufweist, am Ende des Testens in dem Signaturregister (13) eine eindeutige Signatur generiert werden, welche fehlerfrei ein Testergebnis angibt.

Um der Maskierungslogik 14 mitzuteilen, in welchem Fortschritt sich der Testvorgang befindet, ist ein Testmuster-Zähler 15 vorgesehen, welcher ein entsprechendes Signal an die Maskierungslogik 14 und die Bitmodifikationsschaltung 9 liefert.

Die Maskierungslogik 14 ist so programmiert bzw. schaltungstechnisch ausgelegt, dass ihr anhand der Zahl des laufenden Testmusters, die der Testmuster-Zähler liefert, bekannt ist, welche Bits in den Ausgangssignalen der Schaltungsketten 2, 3 und 4 der Applikationsschaltung 1 auswertbar sind und an das Signaturregister 13 weitergegeben werden können bzw. welche Bits mittels der Oder-Gatter 10, 11 und 12 zu sperren sind.

Es ist ferner ein Schiebezyklus-Zähler 16 vorgesehen, dessen Ausgangssignal wiederum an die Bitmodifikationsschaltung 9 und die Maskierungslogik 14 gelangt.

Der Schiebezyklus-Zähler 16 liefert ein Signal, welches der Maskierungslogik 14 den Stand der Schieberegister 2,3 und 4 angibt. Durch den Stand des Zählers 16 ist der Maskierungslogik bekannt, welche Positionen der Schieberegister 2,3 und 4 maskiert werden sollen.

Insgesamt wird durch die erfindungsgemäße Selbsttest-Schaltung ein Testen der Applikationsschaltung 1 auf dem Chip möglich, ohne dass hierbei irgendwelche Einschränkungen bestehen. Es ist keine Modifikation der Applikationsschaltung 1 erforderlich, so dass diese für ihren eigentlichen Betrieb optimal ausgelegt werden kann. Auch ist ein Testen mit vollen Taktraten möglich, da die langsamen, externen Bondverbindungen beim Testen nicht eingesetzt werden müssen. Alle Testvorgänge sind auch für solche Applikationsschaltungen uneingeschränkt möglich, die Bauelemente mit speicherndem oder analogem Verhalten auftweisen.

## Patentansprüche

1. Integrierter Schaltkreis mit einer zu testenden Applikationsschaltung (1) und einer Selbsttest-Schaltung (5-16), welche zum Testen der Applikationsschaltung (1) vorgesehen ist und welche eine Anordnung (5-9) zur Erzeugung deterministischer Testmuster aufweist, die der Applikationsschaltung (1) für Testzwecke zugeführt werden, wobei die durch die Applikationsschaltung (1) in Abhängigkeit der Testmuster auftretenden Ausgangssignale mittels eines Signaturregisters (13) ausgewertet werden,
**dadurch gekennzeichnet,**
**dass** in der Selbsttest-Schaltung (5-16) eine Maskierungslogik (14) vorgesehen ist, welche beim Testen diejenigen Bits der Ausgangssignale der Applikationsschaltung (1) sperrt, die aufgrund des Schaltungsaufbaus der Applikationsschaltung (1) undefinierte Zustände aufweisen, und welche nur die übrigen Bits dem Signaturregister (13) zuführt, und dass der Maskierungslogik (14) ein Testmuster-Zähler (15) zugeordnet ist, welcher der Maskierungslogik (14) ein Signal liefert, das dieser in einem Test laufend eine Kennummer des aktiven Testmusters übermittelt.

2. Integrierter Schaltkreis nach Anspruch 1,
**dadurch gekennzeichnet,**
**dass** der Maskierungslogik (14) ein Schiebezyklus-Zähler (16) vorgesehen ist, welcher der Maskierungslogik (14) ein Signal liefert, welches den Schiebezustand von in der Applikationsschaltung (1) vorgesehenen Schieberegistern (2,3,4) angibt.

## Claims

1. An integrated circuit comprising an application circuit (1) to be tested and a self-test circuit (5-16) which is provided for testing the application circuit (1) and comprises an arrangement (5-9) for generating deterministic test samples which are applied to the application circuit (1) for test purposes, the output signals occurring due to the application circuit (1) in dependence upon the test samples being evaluated by means of a signature register (13), **characterized in that** the self-test circuit (5-16) comprises a masking logic element (14) which, during testing, blocks those bits of the output signals of the application circuit (1) that, based on the circuit structure of the application circuit (1), have undefined states and applies only the other bits to the signature register (13), and **in that** a test sample counter (15) is assigned to the masking logic element (14) to which it supplies a signal that continuously transmits, in a test, an identification number of the active test sample to said masking logic element (14).

2. An integrated circuit as claimed in claim 1, **characterized in that** the masking logic element (14) comprises a shift cycle counter (16) supplying a signal to the masking logic element (14) indicating the shift state of shift registers (2, 3, 4) in the application circuit (1).

## Revendications

1. Circuit intégré muni d'un circuit d'application à tester (1) et d'un circuit d'autotest (5-16) qui est prévu pour le test du circuit d'application (1) et qui présente un dispositif (5-9) de production de modèles de test déterministes qui sont amenés au circuit d'application (1) à des fins de test, les signaux de sortie se produisant par le circuit d'application (1) en fonction du modèle de test étant évalués à l'aide d'un registre de signature (13),
**caractérisé en ce**
**qu'**il est prévu dans le circuit d'autotest (5-16) une logique de masquage (14) qui bloque lors du test les bits des signaux de sortie du circuit d'application (1) qui présentent des états indéfinis en raison de la conception du circuit d'application (1) et qui n'amène au registre de signature (13) que les autres bits et qu'il est affecté à la logique de masquage (14) un compteur de modèle de test (15) auquel la logique de masquage (14) délivre un signal qui transmet en continu à celui-ci un numéro d'identification du modèle de test actif dans un test.

2. Circuit intégré selon la revendication 1,
**caractérisé en ce**
**qu'**il est prévu pour la logique de masquage (14) un compteur de cycles de décalage (16) qui délivre à la logique de masquage (14) un signal qui indique l'état de décalage de registres à décalage (2, 3, 4) prévus dans le circuit d'application (1).
